# EUROPEAN PATENT APPLICATION

(11) **EP 2 592 662 A1**
(43) Date of publication of application: **15.05.2013**
(21) Application number: 11188886.3
(22) Date of filing: 11.11.2011
(51) Int. Cl.: H01L 31/18

(54) **System and method for assembling a solar cell matrix**

(71) Applicant: Somont GmbH, 79224 Umkrich (DE)
(72) Inventor: Knoll, Gerhard, 79224 Umkirch (DE)
(74) Representative: Patentbüro Paul Rosenich AG

(57) **Abstract**

The invention refers to a system (11) for the formation of a matrix (13) of solar cells, having a unit (16) with an input area (17) and an output area (18). Between the input area (17) and the output area (18) the strings (12) are conveyed on the conveying unit (16) in a conveying direction (19). The system (11) further comprising means (31) for placing strings (12) on the input area (17) and rotating means (41, 51, 61) designed to lift a string (12) from the conveying unit (16), rotate that string about axes and lower it onto the same conveying unit (16). The invention refers further to a method using such a system (11).

## Description

The invention concerns to a system and a method for assembling a solar cell matrix.

Solar cell strings are constituted by chains of solar cells positioned one after the other and electrically interconnected by two or more electrical leads, also called ribbons. Typically eight to ten cells are connected in series. This may be done by hand, but is normally accomplished by a device called tabber stringer. Due to their constitution the cells normally have a top face representing the negative electrical pole and a bottom face representing the positive pole. The top face is the photovoltaic active side ("sunny side"). Thus, in a string electrical leads connect the top of one cell with the bottom of the next one. Consequentially, the terminal cells of the strings have either negative polarity or positive polarity.

In the manufacture of solar cell modules a plurality of strings is arranged parallel to each other into a matrix of solar cells. The strings are then connected electrically, provided with end connections and further processed into photovoltaic solar modules ready for use.

In this document the term matrix is used for both strings that are interconnected and string that are not yet interconnected but are already arranged in the desired position and only need to be interconnected. The important point is that the solar cells are all in the position that they will have in the solar module.

Since the solar cells are normally interconnected in series, the strings need to be positioned next to each other with alternating electric polarity orientation to allow their easy connection. When all strings come from one and the same stringer they all have the same polarity orientation and must be rearranged to achieve said alternating orientation when they are placed on the working area, usually a working area. This may be done by rotating every second string emerging from the stringer horizontally about a vertical axis, while the strings preceding and succeeding the turned string are placed on the working area with their original orientation, thus producing an array of strings wherein adjacent strings have opposite electrical polarity orientation. This allows electrically connecting the strings in a meandering fashion. Another option would be to take consecutive strings from two or more stringers producing strings with different polarity orientation which can then be successively placed on the working area in the polarity orientation emerging from each of the two stringers. Moreover, one set of stringers may even deliver strings with the top face up and the other(s) with top face down or bottom face up, respectively.

When the strings are arranged to a matrix it may become necessary that their photovoltaically active top face (sunny side) is either facing upwards or, preferably facing downwards to the working area. If the strings coming from the stringer are placed with the "wrong" side upwards, it is necessary to flip them over so that the previous top side becomes the bottom side.

It is known to realize these string manipulations with robots having arms which pick up and hold the strings by suction and which are integrated into the solar module production line.

While robots are able to position the strings very precisely this kind of manipulation has also disadvantages.

One of the major drawbacks is that robots are highly complex and thus expensive machines which require for their conception, realization, operation and maintenance the input of highly specialized techniques and personnel. This, of course, translates into high process costs. Furthermore, the robot arms which manipulate the strings must be relatively long and are therefore space consuming, a fact that imposes undesirable limits on the flexibility of the production line. Another drawback of such free moving robot arms is that they need a great security area to prevent a danger to the operator. Since the robot arms are heavy, they pose much more danger to operators than equipment according to the present invention.

Another drawback of the conventional manipulation of strings with robot arms having suction grippers is that the solar cells are exposed to mechanical stress which may cause damage, especially when the solar cells are very thin. While this risk may be manageable with sufficient thick cells, being e.g. 180 µm thick, it becomes a huge problem when the thickness goes down, e.g. to 100 µm which is the present trend. The suction heads placed on the robot gripper when engaging the cells deform the cells (also once that are 180 µm thick) what may lead to micro cracks. In this respect one has to consider that in the course of the solar module manufacture such defects may only be detected on the finished product which is an undesirable economic burden.

Of course it is also known from the state of the art to manipulate the strings by hand. However, this also has major drawbacks. The quality of the work strongly depends on the worker's skills. Also, when handled by hand, strings are normally handled by holding them by the electrical leads coming from the first and the last cell of the string. This clearly is disadvantageous for those cells. Further, when the string is lifted from the working area the string hangs in a bow and all cells are exposed a force exerted on them by their respective electrical leads.

It would therefore be desirable to have a technology which is technically less complex than robot manipulation, which allows a space saving design favoring its easy integration into the solar module production line and which is suitable to manipulate solar cell strings of different cell thickness in a safe manner. The technology should be considerably less demanding having regard to its constructional and operational requirements. Furthermore, the system should be automated to secure a high quality of the assembled sola cell matrix. These are the main objectives of the present invention.

These objectives are attained by a system for the formation of a matrix of solar cells, having a conveying unit with an input area and an output area, the input area being adapted to receive strings of solar cells and the output area being adapted to hold the matrix of solar cells, whereby between the input area and the output area the strings are conveyed on the conveying unit, said conveying unit being adapted to move strings in at least one direction, the system further comprising:
means for placing strings on the input area and
at least one rotating means designed to lift a string from the conveying unit, rotate that string about a single axis and lower it onto the same conveying unit.
The main concept of the present invention is to separate the different movements and actions performed by a robot into single actions while the strings are placed and transported on a, normally horizontal, conveying unit. This is a complete turnaround from the conventional robot technique and leads to a highly efficient and economical production of solar cell matrices. Since the movements of the inventive system are limited to the conveying unit or even much smaller areas than that, operators can safely approach the strings being handled for inspection.

This may be accomplished by a series of system stations dedicated to specific tasks.

The rotating means as such is only capable of rotating the string around one axis. The strings are lifted and lowered by additional means as crossbars or beams whereby the lowering is done basically in the same direction as the lifting.

Firstly, the strings coming from a stringer are transferred by a string transfer station onto a conveying unit, e.g. represented by a conveyer belt transporting the strings in production direction. This transfer can be accomplished by a string transfer conveyer, e.g. a conveyer belt, arranged in cross-direction to and above the conveying unit which belt handle or transport a string from a stringer and places it onto the conveying unit, e.g. by bringing the string into engagement with the conveying unit such that the latter can handle or transport the string.

Thereafter the further processing steps depend on the position of the strings as they have been placed on the conveying unit by the string transfer station.

Advantageously the at least one rotating means is an angular adjustment means to rotate a string about a vertical axis in order to adjust its angular position with respect to the conveying direction.

Alternatively or additionally the at least one rotating means is a polarity orientation means to rotate a string about a vertical axis in order to change its polarity orientation.

Alternatively or additionally the at least one rotating means is a flipping means (2) to rotate the string about its longitudinal axis in order to flip it over.

In view of the fact that the invention aims at simplifying the solar matrix production process by separating string positioning steps conventionally performed by robots, it is an aspect of the invention to place the strings on the conveying unit in a provisional manner, i.e. not in the position they must have in the final matrix and thereafter provide position correction means. These means consist of rotating means designed to lift a string from the conveying unit, rotate that string about a single axis and lower it onto the same conveying unit, said rotating means being conceived to perform at least one task.

According to the invention only one of the above mentioned three rotating steps is to be performed depending on the initial string position. This "selected" step may be any of the three steps. It is also within the present invention, that two of the rotating steps are carried out depending of the desired final orientation. Of course, the invention provides also for the execution of three or more steps. As stated above the sequence of these steps, when performed, may change depending inter alia on the initial position and initial orientation of the strings.

In order to achieve the rotation according the aforementioned the string is lifted from the conveying unit, rotated about a vertical axis and lowered onto the conveying unit.

The rotating and/or positioning means may be designed to lift a string in a first direction and rotate it about an axis oriented in the same direction.

The lifting is e.g. accomplished by a crossbar as lifting means which is positioned in a discontinuity of the conveying unit conceived to be able to be lifted and lowered with respect to its resting position at working level and being horizontally rotatable about a vertical axis. Said discontinuity may be an appropriately designed gap between two consecutive conveying device extending perpendicular to the direction of movement or may be one or multiple gaps between the conveying devices extending parallel to the direction of movement. The string is pushed on the crossbar by the conveying unit and lifted by a, in relation to a horizontal plane of the conveying unit, vertical movement of the crossbar. Thereafter the crossbar accomplishes the desired rotation, e.g. about a vertical axis to which it may be joined. Finally the crossbar is again lowered and the string replaced on the conveying unit. Preferably the lifting is done from behind of the surface of the conveying unit whereby from behind means in this relation under the surface of the conveying unit on which the strings are transported.

During manipulation the string may just lie on the lifting means or it may be held, e.g. by mechanical means, electrostatic forces, suction or by other holding means. The holding means comprise, e.g., rubber or sticky lining so that the strings do not move on the lifting means during rotation. Underpressure can be applied to hold the strings on the lifting means by suction.

The angular adjustment means serves to precisely re-position strings which have not yet been positioned correctly with respect to their angular orientation towards the conveying direction. Ideally the strings should be positioned such that their longitudinal axis is perpendicular to the conveying direction. Very small deviations are however tolerable. These deviations should not exceed 1 degree, preferably not exceed 0.5 degree, and more preferably not exceed 0.1 degree.

The polarity orientation means serves to re-orient the electrical polarity of the strings, if this should become necessary e.g. in the case that all strings coming from one stringer and all strings are initially placed on the conveying unit with the same polarity orientation. In this case it normally is necessary to turn every second string horizontally about a vertical axis. This is possibly accomplished with the use of a crossbar in the same way as with the angular adjustment described above.

According to a preferred embodiment the polarity orientation means of the system are conceived to lift a string from the conveying unit, rotate it horizontally about a vertical axis by 180 degree and lower the string back onto the conveying unit. By that, the strings coming from the same stringer and having been transferred to the conveying unit and placed thereupon with the same electrical polarity orientation, can be rearranged in that every second string is subjected to a horizontal 180 degree re-orientation.

The rotation about a vertical axis by 180 degree may be combined with the angular adjustment means. This combined movement may be carried out by two devices. Thereby the rotation about a vertical axis by 180 degree may be carried out by a fast, less accurate device preferably with a large rotation angle and the exact positioning may be carried out by slower, more accurate adjustment means that have a smaller rotation angle.

Compared to string manipulation with robots whose arms have suction grippers this manner of manipulation is much more adequate for strings from thin solar cells, as any deformation of the cells (and consequential mechanical damage) under the sucking action is avoided. It has to be borne in mind that during their 180 degree rotation the strings held by suction on robot arms are exposed to shear forces with respect to the holding device and the ambient air which requires relatively high suction forces to ensure smooth processing without the danger of strings falling off. Smaller movements of strings when supported and held by crossbars for their manipulation need lesser forces, making the use of suction for these purposes less risky.

Another advantage of using a conveyer unit that extends in one plane is that (except for the flipping station) the strings are only rotated around an axis perpendicular to the planes of the cells. This leads to much less aerodynamic pressure or forces on the cells in comparison to the aerodynamic pressure which robots generate. The latter are not very well suited for carrying out rotations about this axis and only transporting the cells in the plane of the cells themselves. Since the cells are very light, the aerodynamic forces on the cells may be larger than the gravitational forces. This means that it is the movement that necessitates a firm holding of the cells.

Again in the interests of an efficient and economic string manipulation the inventive system may content itself with a provisional lateral positioning of the strings on the conveying unit at any step, i.e. that the strings with regards to their alignment in conveying direction are not positioned precisely. To correct any disturbing misalignment of the strings lateral positioning means may be provided, preferably in the conveying direction downstream of the at least one rotating means, designed for lifting a string from the conveying unit, translating it transverse to the conveying direction and lowering the string onto the same conveying unit. This can again be accomplished e.g. by a crossbar situated in a discontinuity of the conveying unit, e.g. between two successive conveyer belts. This crossbar supports the incoming string, holds it while the crossbar is lifted and shifted transversely to the conveying direction, and puts the string back onto the conveying unit in the corrected lateral position.

In a preferred embodiment of the system the polarity orientation means are located in the conveying direction upstream of the angular adjustment means and of the lateral positioning means. By that these latter operations can amend any position errors that may have been occurred before. It is however also possible to perform the polarity re-orientation step as the first rotation after the strings have been placed on the conveying unit by string transfer means transferring the strings from the stringer onto the conveying unit. By that any positioning error after the polarity re-orientation may be corrected.

According to a further embodiment of the invention the rotating means and the lateral positioning means are combined into a single piece of equipment. This renders the system more compact and is especially suitable for systems where only small initial position deviations occur. When a crossbar is used to perform the angular and lateral adjustment, this crossbar, positioned in a discontinuity of the conveying unit, is designed to lift a string, shift it laterally transverse to the conveying direction and as well to rotate it about a vertical axis to which it is joined in order to correct any defective angular positioning.

As for the flipping step provided by the flipping means, this becomes e.g. necessary when in the initial position of the strings the top face (sunny side) of the solar cells faces upwards while it is more preferred to have the top face facing downwards towards the conveying unit. In this situation the rotating means equally provide e.g. for a crossbar which can engage and hold the string to be turned. The crossbar holding the string is then rotated about its longitudinal axis and the turned string is then re-placed in flip-over position on the conveying unit. Holding the strings on the crossbar may be realized by suction, mechanical forces, electrostatic forces or any other suitable means. As mentioned above the holding forces applied need not be very strong and for that reason suction e.g. provided by underpressure is a possible option. Arranging the strings with their top face facing downwards may protect this side of the cell against surface damages, e.g. scratches. Accordingly, the conveying unit surface should be made in this case of a material avoiding any surface damaging design, e.g. rubber or rubber-like material.

Considering the aim of the invention to provide an efficient and economic system for assembling solar cell strings to a matrix, it may also be suitable to adjust the spacing of the strings only shortly before their final assembly to the matrix. Since the spaces between the strings in the final matrix are very small, it would be cumbersome to preserve this narrow spacing throughout the entire string manipulation. Thus according to a further preferred embodiment the system comprises spacing means, preferably in the conveying direction downstream of the lateral positioning means. The spacing means being designed to lift a string from the conveying unit and lower the string onto the same conveying unit without rotating or translating the string, the conveying unit being adapted to move as the string is lifted.

In this process step an incoming strip, lifted from the conveying unit is replaced onto it in compliance with the spacing the strings must have in the final matrix.

In order to achieve the desired string position as precisely as possible, positioning sensors may be integrated into the aforementioned means whereby these sensors are designed to supervise, control and/or detect the correct positioning of the strings. As sensors may e.g. be used optical sensors (cameras, light ray detection means), inductive sensors, and capacitive sensors.

Each station may be provided with other monitoring means for monitoring the operation of the system and preferably for monitoring of each step in the system.

A further preferred embodiment of the inventive system provides a system comprising polarity orientation means conceived to lift a string from the conveying unit, rotate it horizontally about a vertical axis by 180 degree and lower the string back onto the conveying unit, flipping means, and spacing means for arranging the strings with the desired mutual distance.

The inventive system is to be considered as a device able to support flexible operation conditions. The functions of the various stations conform to simple operations which allow a safe, efficient and economical handling of strings for their arrangement into a solar cell matrix.

Further advantages, features and details of the invention follow from the following description which under consideration of the figures describes embodiments of the invention. Thereby the features mentioned in the claims and in the description can be relevant for the invention each alone or in any order of combination.

The list of reference signs forms an integral part of the disclosure. The figures are described in interrelated and comprehensive form. Same reference signs refer to the same component part.

The following drawings are illustrations of a possible design of the inventive system.
- Figure 1: shows an oblique view of one possible realization of the inventive system;
- Figure 2: shows an oblique view of a string transfer station;

- Figure 3: shows a detail view of the string transfer station of Figure 2 in the closed transfer conveyer position, without showing the string;
- Figure 4: shows the string transfer station of Figure 3 in the opened transfer conveyer position;
- Figure 5: shows an oblique view of a flipping over station;
- Figure 6: shows the flipping over station of Figure 5 in detail;
- Figure 7: shows an oblique view of a polarity rotation station;
- Figure 8: shows the polarity rotation station of Figure 7 in detail;
- Figure 9: shows an angular and lateral adjustment station in detail; and
- Figure 10: shows an oblique view of a conveying device.

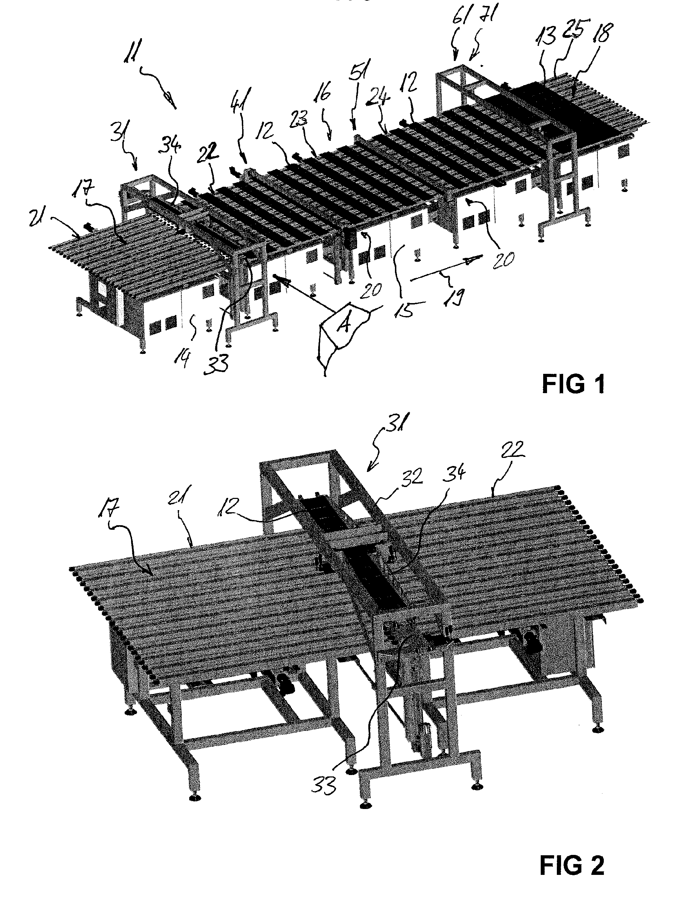

Figure 1 shows an embodiment of an inventive system 11 for the formation of a matrix of solar cells. The system 11 is modular and can be arranged according to the process to be preformed and/or according to the local possibilities or needs, respectively. The system 11 comprising a conveying unit 16 for conveying the strings 12 in at least a conveying direction (arrow 19) having an input area 17 at one end being adapted to receive strings 12 of solar cells and an output area at another end being adapted to hold the matrix 13 of solar cells. In this embodiment a total of five conveying devices 21 to 25 form the conveying unit 16 which are all of the same basic structure and which are aligned in line. Between the conveying devices 21 to 25 spacings are provided and each of them transport the strings 12 from one station to the next station. Control boxes 14 and 15 indicate the location of the control systems for the operation of the system 11. The spacings between the conveying devices 21 to 25 are made so small that strings 12 being transported over the conveying unit 16 are always stably supported by one or two conveying devices 21 to 25 in such a way that strings 16 can be stopped at any position on or along the conveying unit 16.

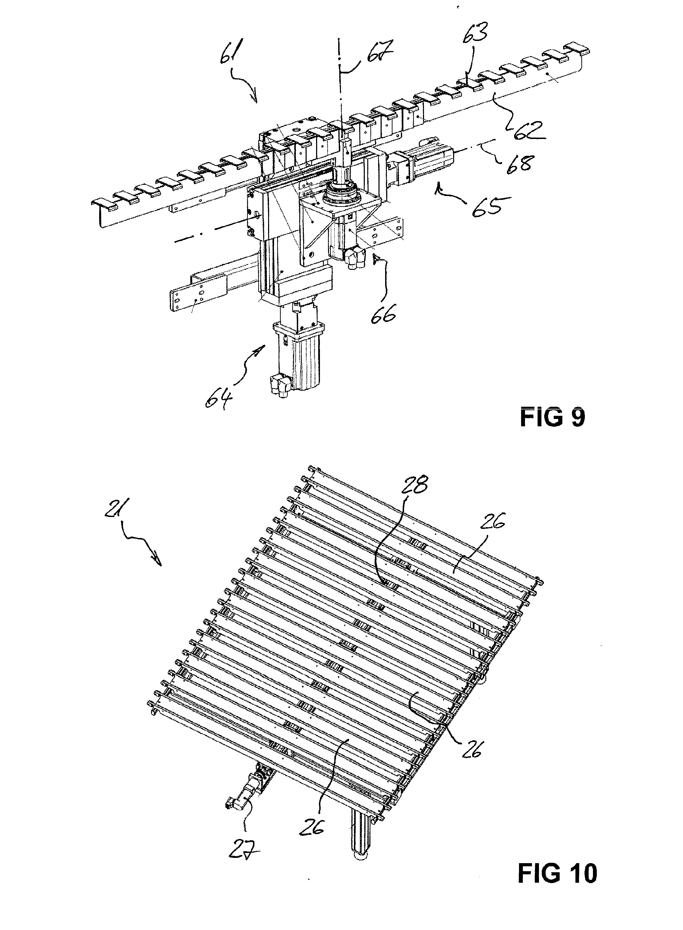

As can be seen best from figure 10, each conveying device 21 to 25 may be constituted in cross direction by a number of small conveyer belts 26 which are driven by a motor 27 and by one common axle. Alternatively, the conveyer belts 26 or the respective conveying device are driven separately.

Preferably situated at the locations of the spacings between these separate conveying devices 21 to 25 various stations are located in conveying direction 19.

Referring back to figure 1, a transfer station 31 as means for placing strings 16 on the input area 17 is provided over input area 17. The strings 12 are transferred from a tabber stringer A via the transfer station 31 onto the conveying device 21 and then conveyed to a flipping station 41 as a flipping means arranged between conveying device 22 and conveying device 23 to rotate the string 12 about its longitudinal centre axis in order to flip it over. The previous top side of the string 12 will come to the bottom side of the string 12. In many cases the strings 12 arrive from the transfer station 1 with their top face (sunny side) up and are flipped over so that this side then faces the conveyer surface. The flipping station 41 forms the first rotating means. If the strings 12 come from the stringer A with the top face down or the matrix 13 is made with the top face down, this flipping station 41 can be omitted.

Downstream of the flipping station 41 follows a polarity orientation station 51 arranged between conveying device 23 and conveying device 24. The polarity orientation station 51 as a polarity orientation means which is designed to rotate a string 12 by about 180 degree about a vertical axis in order to change its polarity orientation with respect to the orientation before the rotation. In this application vertical means a direction extending perpendicular to the conveying surface of the conveying unit 16. If the strings 12 are coming from just one stringer A, they are all placed by the transfer station 31 on the conveying unit 16 with the same polarity orientation, i.e. pointing with identically charged electrical poles in the same direction. After rotating every second string by 180 degrees, the string dipoles alternate with regard to their electrical orientation. The polarity orientation station 51 forms a second rotating means.

The next station in conveying direction 19 is an adjustment station 61 as an angular adjustment means and lateral positioning means. The adjustment station 61 is designed to rotate the string 12 about a vertical axis in order to adjust its angular position with respect to the conveying direction 19. Thereby a lacking precision of the strings' angular position with respect to the conveying direction is corrected to correspond as precisely as required to 90 degree or put differently exactly parallel to the string 12 downstream of it. Furthermore, the adjustment station 61 as a lateral positioning means is designed to shift the strings 12 in transverse direction to the conveying direction 19 in order to align them with respect to the conveying direction 19 or the string 12 next to it. Here the rotating and the lateral positioning means are combined into a single piece of equipment.

After that, the strings 12 with their correct angular and lateral position are arranged by a spacing station 71 as spacing means. The spacing station 71 is conceived to regulate the distance between adjacent strings 12 to correspond to the desired situation in the final solar cell matrix 13. This goal is achieved by appropriate movements of the successive conveying device 24 before and the conveying device 25 after the spacing station 81, such that a string 12 incoming from the spacing station 71 is transported from the conveying device 25 after that spacing station 71 with the right spacing. The string 12 coming to the station 71 is lifted so that it is not transported as the string 12 coming from the conveying device 25 is move to the correct relative position. Are the strings 12 in the correct position, then the lifted string 12 is lowered onto the conveyer unit 16, thus achieving the desired relative position the preceding string 12. In that final position the strings 12 arrive at the output area 18 where the further processing of the ready-made string matrices 13 into solar cell modules starts. Normally in a first step the strings 12 are now interconnected.

All lifting is basically done perpendicular to the surface of the conveying unit 16.

The strings 12 consist of a series of solar cells with small gaps in between (light coloured lines in conveying direction 19) which are electrically connected by two leads (light coloured lines in cross direction). According to the drawing each string 12 comprises twelve solar cells, but this may be different, depending on the module layout. While before the adjustment station 61 the space between adjacent strings 16 is relatively big it becomes narrow thereafter in the matrix shown in the output area 18. Preferably, the inventive system 11 does not have to be adapted to the number of cells in a string 12. If suction cups are used to hold the cells of a string 12, the number of cells may not be lower than the number of suction heads because the cups that are not covered by a cell will such in too much air, rendering the under-pressure in the system too low for holding the string 12. Since according to the invention the strings 12 are supported from below, making the string 12 shorter will not lead to any problems. This makes the inventive system 11 especially suited for interchangeably manufacturing different modules shapes.

A sensor system 20 is shown designed to supervise, control and/or detect the correct position of the strings 12 and arranged on flipping station 41. Analogous sensor systems may be used to supervise the string 12 positions after all stations.

According to the invention, the stations may be placed in any order. The order shown in figure 1 was found to be highly beneficial.

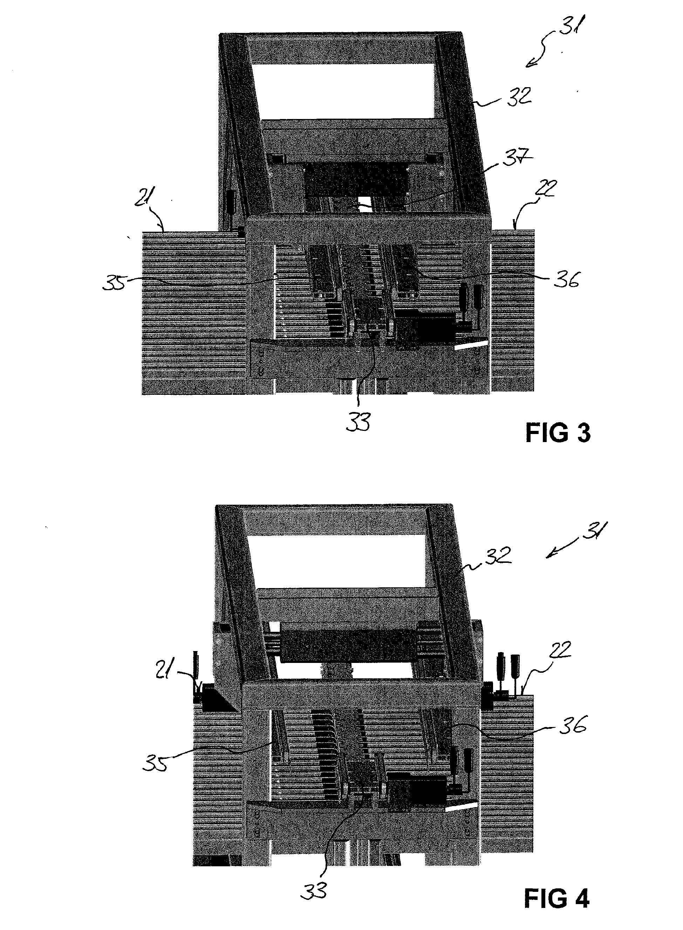

Figures 2 to 4 show in more detail the transfer station 31. The transfer station 31 comprises a bridge construction 32 above a conveying unit 16. Within said bridge construction 32, in transverse direction to the system's 11 main conveying direction 19, a first transfer conveyer 33 is arranged which takes up the strings 12 arriving from a stringer A and conveys it to a second transfer conveyer 34 which is aligned in the same direction as the first transfer conveyer 33. The second transfer conveyer 34 comprises two independent conveyer belt arrangements 35 and 36 (each consisting of two small conveyer belts). The second transfer conveyer 34 takes the string 12 up in its closed position (Figure 3). A transfer or holding beam 37 as lifting means is lifted in direction of the second transfer conveyer 34. Then the conveyer belt arrangements 35 and 36 are lowered and moved apart in a opened position (i.e. the gap between the two conveyer belts widened), as shown in Figure 4, to set the string 12 free for engagement with the transfer beam 37 which is lowered down that the string 12 comes into engagement with the conveying unit 16. The string 12 can now be conveyed by the conveying unit 16 from one station to the next station. The transfer beam 37 is designed to extend thru the conveyer unit 16. In the shown embodiment this is achieved by forming a gap between two conveying devices 21 and 22. If no gap would be present the transfer beam 37 will have a more complex structure for doing the same job or operation, respectively. The same consideration applies for every transfer or holding beams or crossbar of every station of the system 11. The transfer or holding beams according to the preferred embodiment are designed much like the one shown in figure 9.

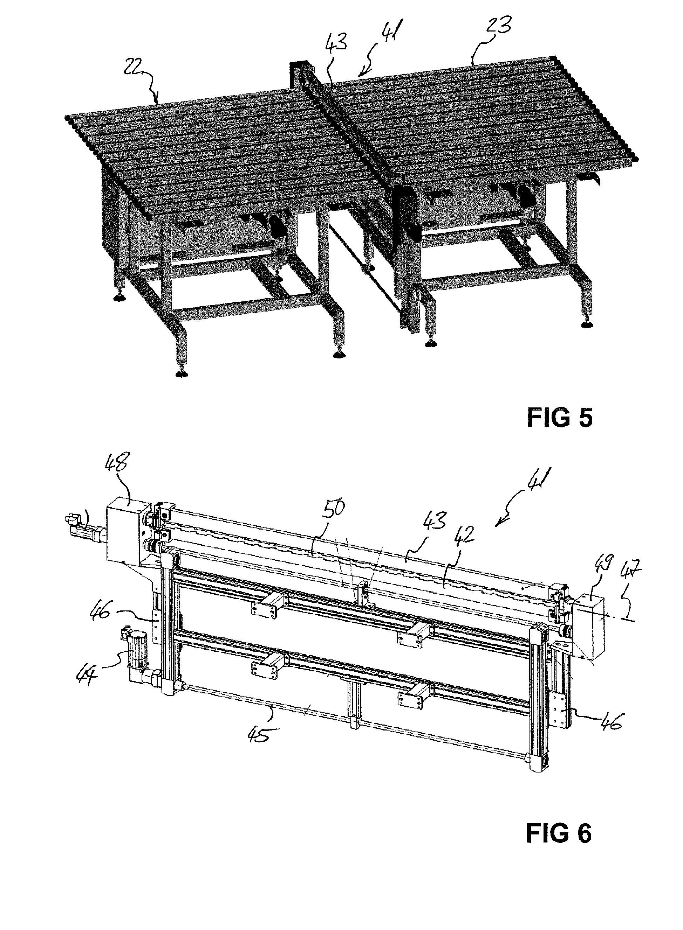

Figures 5 and 6 illustrate the flipping station 41 which comprises a first crossbar 42 and a second crossbar 43 being situated above first crossbar 42. In its initial situation the second crossbar 43 is located above the working area of the conveying unit 16 and the first crossbar 42 is located below in a gap between two consecutive conveying devices 22 and 23 of the conveying unit 16 such that it is able to support a string 12 incoming from the adjacent upstream conveying device 22. The width of the first crossbar 42 and also the width of the afore-mentioned gap are much smaller than the width of the strings 12. When a string 12 is carried along by the upstream conveying device 22 and positioned exactly above the gap between the upstream conveying device 22 and the downstream conveying device 23, it bridges this gap. In this situation the first crossbar 42 as a lifting means is vertically lifted towards the upper second crossbar 43. For lifting the first crossbar 42 a motor 44 and an axle 45 is provided which acts on two lifting mechanism 46 coupled to the first crossbar 42. By that the string 12 may thereafter become clamped between the two crossbars 42 and 43. In this situation the crossbars 42 and 43 are lifted further - to gain clearance - and then rotated about a longitudinal axis 47. For this rotation an active rotary unit 48 comprising a further motor is provided on one end of the crossbars 42 and 43 and a passive rotary unit 49 is provided on the other end of the crossbars 42 and 43. By that movement the string's 12 upper side becomes its lower side. When thereafter the crossbars 42 and 43 are lowered again to their initial position, the flipped over string 12 is re-placed over the gap between the upstream conveying device 22 and the downstream conveying device 23 and further taken along by the downstream conveying device 23 in conveying direction 19. For supporting and carrying the strings 12 at least one of the crossbars 42 and 43 can be provided with string support plates 50 which are wider than the crossbars 42 and 43 themselves. The string support plates 50 can be provided with openings along their longitudinal extension that their free ends are capable of entering spaces between the conveyer belts of the respective conveying device 22 and/or 23. Alternatively the string support plates 50 are smaller than the gap between the conveying devices 22 and 23. The surface of the crossbar(s) 42 and/or 43 can be provided with holding means to prevent any undesired movement of the string 12 during the operation of the flipping station 41. The holding means may preferably have a relative high friction with the cells or they may actively hold the cells, e.g. by means of eddy currents, (electro-)magnets, underpressure. The same consideration applies for every transfer or holding beams or crossbar of every station of the system 11.

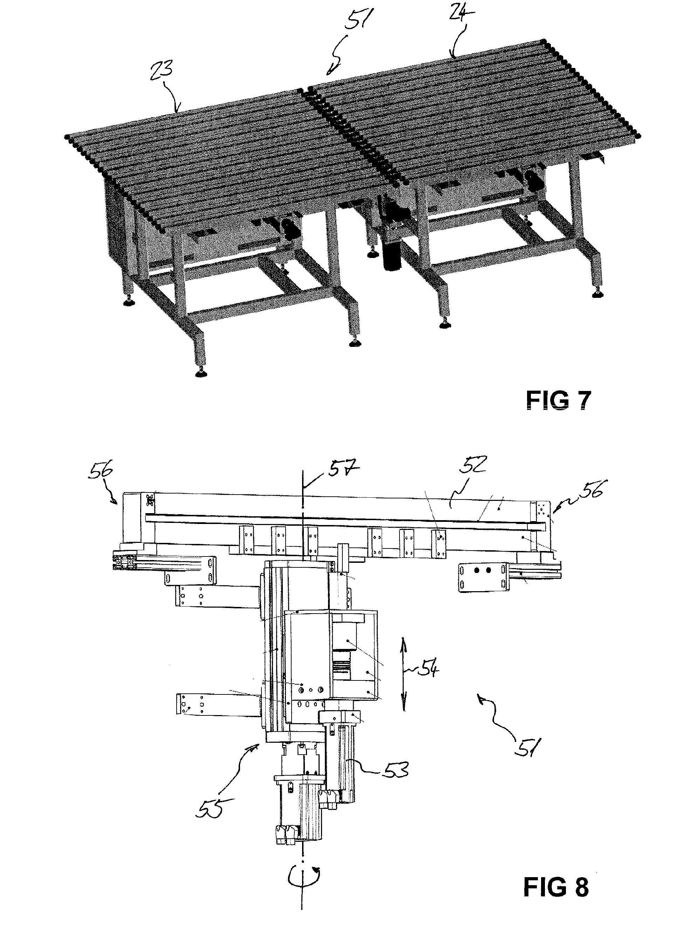

Figures 7 and 8 illustrate the polarity orientation station 51 comprising a crossbar 52 is provided to support and hold the string 12 whose polarity orientation is to be changed. As the flipping station 41 the polarity orientation station 51 is arranged in the gap between consecutive conveying devices 23 and 24. The gap is smaller than the width of the strings 12 which are therefore able to bridge this gap. When a string is positioned thereupon a crossbar 52 is lifted vertically by action of a lifting motor 53 in direction of arrow 54. Thereafter the crossbar 52 bearing the string 12 is rotated by 180 degree by action of the motor/gear box system 55 about a vertical axis 57 and then lowered that the string 12 can be further transported by the downstream conveying device 24. An active clamping system 56 located at the ends of the crossbar 52 may be used to hold the string 12 in position. The surface of the crossbar 52 can be provided with holding means to prevent any undesired movement of the string 12 during the operation of the polarity orientation station 51, see above. Note that if the strings 12 are provided with alternating polarity, the polarity orientation station 51 may be omitted. This may for example be the case if two stringers are used which deliver the strings 12 each in the respective orientation.

Figure 9 illustrates the adjustment station 61 which allows an angular adjustment and/or lateral positioning of the string 12. The adjustment station 61 is arranged in the gap between consecutive conveying devices 24 and 25. The adjustment station 61 comprises a crossbar 62 which is small in the conveying direction 19 and which has a series of string support plates 63 which are wider than the crossbar 62 itself. A clamping system is not essentially required for this position adjustment. The crossbar 62 can be shifted in different directions for a perfect alignment of the string 12. Firstly the crossbar 62 is lifted by a first motor/gear system 64 along a vertical axis 67. Then the crossbar 62 may be swivelled about the vertical axis 67 by a second motor/gear system 66. Additionally or alternatively, the crossbar 62 is laterally displaced in a direction along a horizontal axis 68 which is essentially parallel to the conveyer surface. For this alignment a third motor/gear system 65 is provided. By that any lack of precision of the strings' position may be corrected so that the strings 16 are afterwards in perfect parallel alignment. Afterwards the crossbar 62 is lowered that the aligned string 12 can be transported by the conveying device 25 to the output area 18.

All motors in this embodiment may be electrical servo-motors and may be replaced by manual manipulating means.

In the shown embodiment the transfer station 31, flipping station 41, orientation station 51 and adjustment station 61 are shown to be placed between two conveying devices. They may also be placed more near the centre of one conveying device as is shown in figure 2 in relation to the transfer station 31.

### List of reference signs

- 11: system
- 12: string
- 13: matrix
- 14: control box
- 15: control box
- 16: conveying unit
- 17: input area
- 18: output area
- 19: conveying directin (arrow)
- 20: sensor
- 21: conveying device
- 22: conveying device
- 23: conveying device
- 24: conveying device
- 25: conveying device
- 26: conveyer belt
- 27: motor of 21
- 28: axle of 21
- 31: transfer station
- 32: bridge construction
- 33: first transfer conveyer
- 34: second transfer conveyer
- 35: conveyer belt arrangement
- 36: conveyer belt arrangement
- A: stringer

- 41: flipping station
- 42: first crossbar of 41
- 43: second crossbar of 41
- 44: motor
- 45: axle
- 46: lifting mechanism
- 47: longitudinal axis of 41
- 48: active rotary unit
- 49: passive rotary unit
- 50: string support plate
- 51: polarity orientation station
- 52: crossbar of 51
- 53: lifting motor
- 54: arrow (Z-axis)
- 55: motor/gear system
- 56: active clamping system
- 57: vertical axis
- 61: adjustment station
- 62: crossbar of 61
- 63: string support plate
- 64: first motor/gear system
- 65: second motor/gear system
- 66: third motor/gear system
- 67: vertical axis
- 68: horizontal axis
- 71: spacing station

## Claims

1. System for the formation of a matrix (13) of solar cells, having a conveying unit (16) with an input area (17) and an output area (18), the input area (17) being adapted to receive strings (12) of solar cells and the output area (18) being adapted to hold the matrix (13) of solar cells, whereby between the input area (17) and the output area (18) the strings (12) are conveyed on the conveying unit (16), said conveying unit (16) being adapted to move strings (12) in at least one conveying direction (19), the system (11) further comprising:
means (31) for placing strings (16) on the input area (17) and
at least one rotating means designed to lift a string (12) from the conveying unit (16), rotate that string (12) about a single axis and lower it onto the same conveying unit (16).

2. System according to claim 1 wherein the at least one rotating means is an angular adjustment means (61) to rotate a string (12) about a vertical axis (67) in order to adjust its angular position with respect to the conveying direction (19).

3. System according to claim 1 or 2 wherein the at least one rotating means is a polarity orientation means (51) to rotate a string (12) about a vertical axis (57) in order to change its polarity orientation, preferably upstream of the angular adjustment means.

4. System according to any of claims 1 to 3 wherein the at least one rotating means is a flipping means (41) to rotate the string (12) about its longitudinal axis in order to flip it over.

5. System according to any of claims 1 to 3 further comprising lateral positioning means (61), preferably in direction of the conveying direction (19) downstream of the at least one rotating means, designed for lifting a string (12) from the conveying unit (16), translating it transverse to the conveying direction (19) and lowering the string (12) onto the same conveying unit (12).

6. System according to claim 1 and 5 wherein the rotating and the lateral positioning means (61) are combined into a single piece of equipment.

7. System according to any of claim 1 to 6 wherein at least one of the rotating means comprises lifting means for lifting the strings (12) in relation to the conveying unit (16) preferably from behind, whereby preferably holding means are provided on the lifting means.

8. System according to any of claims 1 to 7 further comprising spacing means (71), preferably in direction of the conveying direction (19) downstream of the angular adjustment and/or the lateral positioning means (61) for bringing strings (12) in the desired spacing.

9. System according to any of claims 4 to 8 wherein a plurality of rotation means is provided and wherein the flipping means (41) as a first rotating means are located in direction of the conveying direction (19) upstream of the further provided rotating means (51, 61).

10. System according to any of claims 3 to 9 wherein the polarity orientation means (51) as a second rotation means-which are preferably located in direction of the conveying direction (19) upstream of the adjustment means (61) as a third rotation means - are conceived to lift a string (12) from the conveying unit (16), rotate it horizontally about a vertical axis (57) by about 180 degrees and lower the string (12) back onto the conveying unit (16).

11. System according to any of claims 1 to 10 wherein positioning sensors (20) are integrated into the at least one rotation means, where these sensors (20) are designed to supervise, control and detect the correct positioning of the strings (12).

12. System according to any of claims 1 to 11 wherein the conveying unit (16) comprising a single conveyer belt or multiple conveyer belts (26) arranged next to each other in the conveying direction (19) and/or in the direction perpendicular to the conveying direction (19).

13. System according to any of claims 1 to 12 comprising as rotation means polarity orientation means (51) conceived to lift a string (12) from the conveying unit (16), rotate it horizontally about a vertical axis (57) by 180 degree and lower the string (12) back onto the conveying unit (16),
flipping means (41), and
spacing means (71) for arranging the strings (12) with the desired mutual distance.

14. System according to any of claims 1 to 13 comprising a transfer station (31) designed to place the strings (12) coming from a stringer (A) on the conveying unit (16) which transfer station (31) comprises a transfer conveyer (33, 34), preferably a conveyer belt, arranged in cross-direction to and above the conveying unit (16) which transfer conveyer (33, 34) transport a string (12) from the stringer (A) and places it onto the conveying unit (16), that the conveying unit (16) can handle or transport, respectively, the string (12).

15. Method for the formation of a matrix (13) of solar cells using a system (11) according of any of claims 1 to 14 comprising the steps of transferring a string (12) from a stringer (A) onto the input area (17) of the conveying unit (16) by a means (31) for placing strings (12);
moving the string (12) by the conveying unit (16) in a conveying direction (19) to at least one rotating means (41, 51, 61) for bringing the string (12) into the desired orientation;
lifting the string (12) from the conveying unit (16) by the at least one rotating means (41, 51, 61);
rotating that string (12) about a single axis by the at least one rotating means (41, 51, 61); and
lower the string (12) onto the same conveying unit (16).
